## Europäisches Patentamt
## European Patent Office
## Office européen des brevets

(19)

(11) Veröffentlichungsnummer : **0 226 033**
**B1**

(12) **EUROPÄISCHE PATENTSCHRIFT**

(45) Veröffentlichungstag der Patentschrift :
20.09.89

(21) Anmeldenummer : 86115588.5

(22) Anmeldetag : 11.11.86

(51) Int. Cl.⁴ : **B 65 G 47/91, H 05 K 13/00**

(54) Vorrichtung zur Aufnahme und zum Transport von Bauteilen.

(30) Priorität : 12.11.85 CH 4831/85

(43) Veröffentlichungstag der Anmeldung :
24.06.87 Patentblatt 87/26

(45) Bekanntmachung des Hinweises auf die Patenterteilung : 20.09.89 Patentblatt 89/38

(84) Benannte Vertragsstaaten :
AT BE CH DE FR GB IT LI LU NL SE

(56) Entgegenhaltungen :
CH--A-- 538 412
DE--C-- 850 797
FR--A-- 2 154 414

(73) Patentinhaber : Zevatech AG
Römerstrasse 6
CH-4512 Bellach (CH)

(72) Erfinder : Gfeller, Martin
Unterfeld 39
CH-3314 Schalunen (CH)
Erfinder : Wanner, Rudolf
Sonnhaldenweg 27
CH-4522 Rüttenen (CH)

(74) Vertreter : Lauer, Joachim, Dr.
Hug Interlizenz AG Austrasse 44 Postfach
CH-8045 Zürich (CH)

Jouve, 18, rue St-Denis, 75001 Paris, France

## Beschreibung

Die vorliegende Erfindung bezieht sich auf eine Vorrichtung zur Aufnahme und zum Transport von Bauteilen nach dem Oberbegriff des Patentanspruches 1.

Unter dem Begriff Bauteile können z. B. in erster Linie elektronische Komponenten verstanden werden, die aus einem Magazin, von einem Zuführorgan oder dgl. bzw. von einem Trägerband ergriffen werden, zu einer Montagestation gebracht und dort auf einem Bauteileträger abgesetzt werden müssen. Andererseits ist der Begriff « Bauteile » auch in einem weiteren Sinn interpretierbar, umfasst also jegliche Art von insbesondere kleinsten und kleinen Bauteilen bis zu einer Abmessung von, grob gesagt, 50 × 50 mm, die erfasst, transportiert und an einer vorgegebenen Stelle wieder abgesetzt werden sollen.

Zu diesem Zweck haben sich die sogenannten « Sauggriffel » bewährt, die im Stand der Technik mehrfach vorbeschrieben sind. Ein solcher Sauggriffel umfasst im wesentlichen einen nadelartigen, hohlen, enseitig offenen Greifkörper, dessen Innenraum an eine Unterdruckquelle angeschlossen ist. Durch Aufsetzen des nadelartigen Greiforgans auf dem zu erfassenden und zu transportierenden Bauteil und durch anschliessendes Aufbauen des Unterdruckes kann das Bauteil ergriffen und an einen vorbestimmten Platz transportiert werden.

In der Praxis müssen Bauteile unterschiedlicher Grösse in der beschriebenen Weise gehandhabt werden. Das Grössenspektrum erstreckt sich dabei von beispielsweise einigen wenigen Quadratmillimetern bis zu Hunderten von Quadratmillimetern. Aus der Überlegung heraus, dass grössere Bauteile zum einen schwerer sind und deshalb eine grössere Ansaugkraft erfordern und zum anderen eine grössere Angriffsfläche für den Sauggriffel bieten, dass bei kleineren Bauteilen die Verhältnisse jedoch genau umgekehrt sind, geht hervor, dass an den Sauggriffel — je nach Bauteilgrösse — unterschiedliche Anforderungen zu stellen sind.

Ein Sauggriffel für kleine und kleinste Bauteile soll einen möglichst geringen Durchmesser aufweisen, wobei die erforderliche Ansaugkraft ebenfalls nur sehr gering sein muss. Bei einem Sauggriffel für grössere Bauteile hingegen spielt die Dimension desselben eine untergeordnete Rolle ; wesentlich ist hier, dass die Ansaugkraft genügend hoch ist, um das Bauteil sicher zu erfassen und zu transportieren. Diese Anforderungen haben bisher dazu geführt, die Art und die Grösse des « Sauggriffels » an die zu erfassenden und zu transportierenden Bauteile anzupassen, wobei entweder Kompromisse bzw. Unzulänglichkeiten bei Verwendung ein und desselben Sauggriffels oder aber eine Auswechslung desselben, je nach zu erfassendem Bauteil, in Kauf genommen werden mussten.

Es ist die Aufgabe der vorliegenden Erfindung, diese Nachteile zu vermeiden und eine Vorrichtung zur Aufnahme und zum Transport von Bauteilen der im Oberbegriff des Patentanspruchs 1 genannten Art zu schaffen, die sich weitgehend für alle Arten von Bauteilen, gleichviel ob klein oder gross, eignet.

Die Lösung dieser Aufgabe ergibt sich aus dem Kennzeichen des Patentanspruches 1, wobei in den abhängigen Ansprüchen Weiterbildungen des Erfindungsgegenstandes und bevorzugte Ausführungsformen desselben umschrieben sind.

In den beiliegenden Zeichnungen sind Ausführungsbeispiele des Erfindungsgegenstandes schematisch dargestellt. Hierin zeigt :

Fig. 1 einen Längsschnitt einer erfindungsgemässen Vorrichtung in einer ersten Arbeitsstellung, wobei nur die eine, axialsymmetrische Hälfte der Vorrichtung dargestellt ist,

Fig. 2 einen Schnitt analog Fig. 1 in einer zweiten Arbeitsstellung,

Fig. 3 einen Schnitt analog Fig. 1 einer dritten Arbeitsstellung,

Fig. 4 ein schematisches Block-Funktionsdiagramm einer erfindungsgemässen Vorrichtung mit einem Greifkörper der in Fig. 1 bis 3 gezeigten Art, jedoch mit einer Bauteil-Zentrierevorrichtung,

Fig. 5 bis Fig. 7 einen Axialschnitt des unteren Endbereiches eines erfindungsgemässen Greifkörpers mit angesaugtem Bauteil in je einer Vertikalstellung I bzw. II bzw. III und mit einer in Angriffsstellung an dem Bauteil befindlichen Zentriervorrichtung,

Fig. 5a bis Fig. 7a je eine Darstellung entsprechend Fig. 5 bzw. Fig. 6 bzw. Fig. 7, jedoch in einer dagegen um 90° bezüglich der Längsachse des Greifkörpers verdrehten Schnittebene, und

Fig. 8 eine Seitenansicht der Zentriervorrichtung gemäss Blickrichtung VIII in Fig. 5.

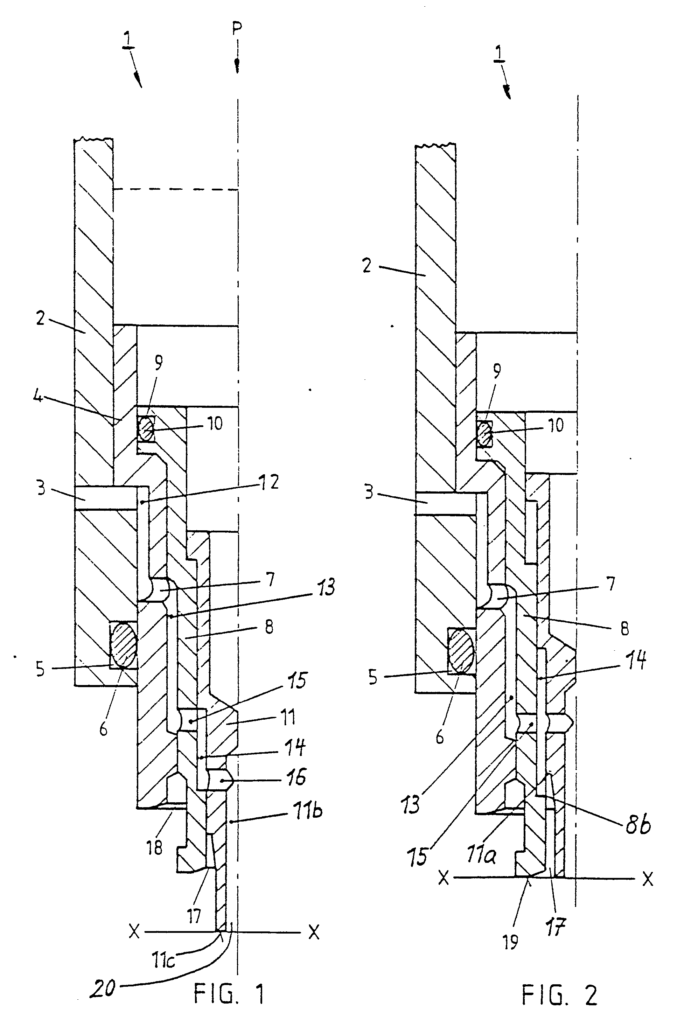

Die in den Figuren 1 bis 3 dargestellte Vorrichtung umfasst einen insgesamt mit 1 bezeichneten Greifkörper, der seinerseits mit einem Grundteil 2 versehen ist. Letzteres ist als Hohlkörper ausgebildet und mit einer radial in sein Inneres verlaufenden Bohrung 3 als Anschluss zu einer (nicht dargestellten) Unterdruckquelle versehen. Im hohlen Inneren des Grundteiles 2 ist ein erstes Greifelement 4 verschiebbar gelagert. Die Abdichtung zwischen Grundteil 2 und Greifelement 4 erfolgt durch einen in einer Nut 5 aufgenommenen O-Ring 6.

Unabhängig davon, wie das erste Greifelement 4 positioniert ist, sorgt eine Radialbohrung 7 dafür, dass das Innere des als Hohlkörper ausgebildeten Elementes 4 stets mit dem Unterdruckanschluss 3 verbunden ist.

Im Inneren des ersten Greifelementes 4 ist im Beispielsfall ein zweites Greifelement 8, ebenfalls axial verschiebbar, angeordnet. Die Abdichtung gegenüber dem ersten Greifelement 4 erfolgt durch einen in einer Nut 9 angeordneten O-Ring 10.

Innerhalb des zweiten Greifelementes 8 ist ein drittes Greifelement 11 angeordnet, das ebenfalls in axialer Richtung verschiebbar gelagert ist. Die Verbindung vom Unterdruckanschluss 3 bzw. von einem mit diesem verbundenen ersten Zwischenraum 12, der zwischen dem Greifkörper-Grundteil 2 und dem ersten Greifelement 4 angeordnet ist, zu einem zweiten Zwischenraumes 13, der zwischen dem ersten und zweiten Greifelement 8 angeordnet ist, erfolgt über eine radiale Bohrung 7. Ein dritter Zwischenraum 14, der zwischen dem dritten und zweiten Greifelement angeordnet ist, steht über eine Radialbohrung 15 mit dem zweiten Zwischenraum 13 und darüber mit dem Unterdruckanschluss 3 in Verbindung. Der Innenraum 11b des dritten Greifelementes 11 schliesslich ist durch eine Radialbohrung 16 mit dem dritten Zwischenraum und darüber mit dem Unterdruckanschluss 3 verbunden.

In Fig. 1 ist die Arbeitsstellung der Vorrichtung dargestellt, in welcher die drei Greifelemente 4, 8 und 11 ausgefahren sind. Insbesondere aus Fig. 1 ist zu ersehen, dass das innerste, dritte Greifelement 11 den geringsten Durchmesser aufweist. Es wird deshalb dazu verwendet, Bauteile kleiner und kleinster Abmessungen zu erfassen. Im praktischen Betrieb bedeutet dies, dass der gesamte Greifkörper 1 so weit in Axialrichtung P ausgefahren wird, bis die Spitze 11c des dritten Greifelementes 11 die Höhenlage der Oberfläche des ergreifenden Bauteiles erreicht. Diese Höhenlage ist in Fig. 1 bis 3 jeweils mit der Linie X-X symbolisiert. Nach dem Auftreffen der Spitze 11c auf der Bauteiloberfläche baut sich der Unterdruck vom Anschluss 3 über den ersten Zwischenraum 12, die Bohrung 7, den zweiten Zwischenraum 13, die Bohrung 15 und den dritten Zwischenraum 14 auf, so dass das Bauteil durch die am Ende des dritten Greifelementes 11 vorgesehene Saugöffnung 20 ergriffen wird. Aus Fig. 1 ist weiter ersichtlich dass die am zweiten Greifelement 8 vorgesehene Saugöffnung 17 wie auch die am ersten Greifelement vorgesehene Saugöffnung 18 verschlossen sind.

Soll ein grösseres Bauteil erfasst und transportiert werden, wird der Greifkörper 1 zufolge Fig. 2 aus der in Fig. 1 angedeuteten Lage gemäss Pfeil P weiter in Richtung gegen die Höhenlage X-X abgesenkt. Dabei verschiebt sich das dritte Greifelement 11 axial entgegen der Pfeilrichtung P so weit in das Innere des Greifkörpers 1, bis die Stirnfläche 19 des zweiten Greifelementes 8 und damit die Saugöffnung 17 ebenfalls auf der Oberfläche des zu ergreifenden Bauteiles aufliegt.

Durch diese gegenseitige axiale Verschiebung der Greifelemente tritt die Saugöffnung 17 am bauteileseitigen Ende des zweiten Greifelementes 8 mit dem Unterdruckanschluss 3 über die Bohrungen 15 und 7 sowie die Zwischenräume 14, 13 und 12 in Verbindung. Dies bedeutet, dass zwei konzentrische Saugöffnungen, nämlich die Saugöffnung 17 des dritten Greifelementes 11 sowie die Saugöffnung 20 des zweiten Greifelementes 8 aktiviert sind. Es steht daher eine flächenmässig grössere und damit wirkungsvollere Saugfläche zur Verfügung, um grössere Bauteile zu erfassen und gegebenenfalls zu transportieren.

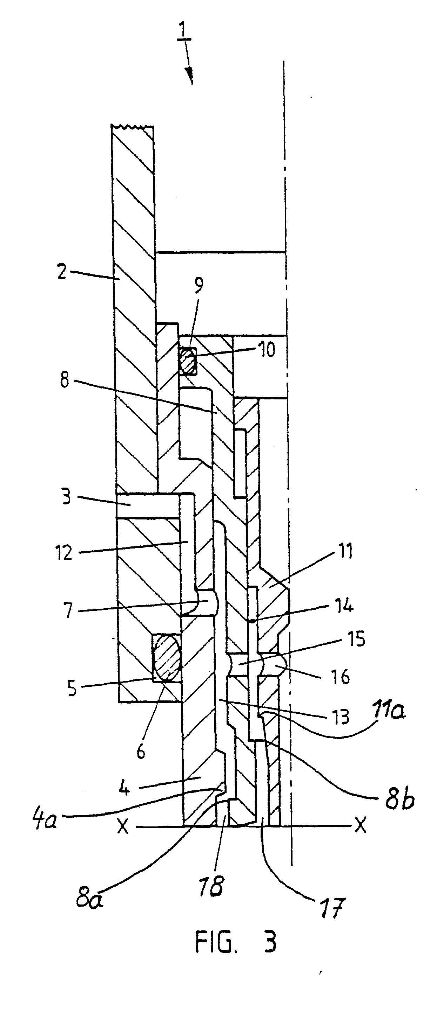

In Fig. 3 schliesslich ist nicht nur das dritte Greifelement 11, sondern auch das zweite Greifelement 8 axial entgegen der Richtung des Pfeiles P verschoben, so dass die Saugöffnung 18, die dem ersten Greifelement 4 zugeordnet ist, ebenfalls in Funktion tritt. Zur Erfassung flächenmässig grosser Bauteile treten also nunmehr alle drei Greifelemente 4, 8 und 11 mit der Oberfläche des zu erfassenden Bauteiles in Berührung, wobei der Unterdruck vom Anschluss 3 über den Zwischenraum 12, die Bohrung 7, den Zwischenraum 13, die Bohrung 15, den Zwischenraum 14 und die Bohrung 16 innerhalb der drei ringförmig konzentrisch angeordneten Saugöffnungen auf die Oberfläche des Bauteiles einwirkt.

Die vorstehend beschriebene, durch die Greifelemente gebildete Teleskopanordnung ermöglicht bei der Axialverschiebung der Greifelemente relativ zueinander eine Steuerwirkung, welche den Unterdruck vom Anschluss 3 im Laufe einer Absenkbewegung des Greifkörpers jeweils aufeinanderfolgend zur Saugöffnung des ersten und des zweiten Greifelementes durchschaltet, sobald die betreffende Saugöffnung auf der Bauteiloberfläche aufgesetzt hat. Hierzu sind die Greifelemente mit paarweise zusammenwirkenden Steuerkanten 4a und 8a sowie 8b und 11a versehen. In der Arbeitsstellung gemäss Fig. 1 sind die von beiden Steuerkantenpaaren gebildeten Durchlässe verschlossen, in derjenigen gemäss Fig. 2 ist nur der Durchlass des Steuerkantenpaares 8b und 11a geschlossen, und in derjenigen gemäss Fig. 3 sind die Durchlässe beider Steuerkantenpaare offen.

Mit der vorstehend beschriebenen Vorrichtung ist die Möglichkeit geschaffen, kleine und kleinste Bauteile, welche eine verhältnismässig geringe Ansaugkraft erfordern, lediglich mit dem dritten Greifelement 11 zu erfassen, dessen Abmessungen gering gehalten sind. Sobald ein mittelgrosses Bauteil zu erfassen ist, wird der Greifkörper weiter abgesenkt, so dass die Saugwirkung des dritten Greifelementes 11 durch die Saugwirkung des zweiten Greifelementes 8 unterstützt wird. In entsprechender Weise wirkt das erste Greifelement 4, welches das zweite Greifelement 8 konzentrisch umgreift, unterstützend zur Erfassung von verhältnismässig grossen Bauteilen.

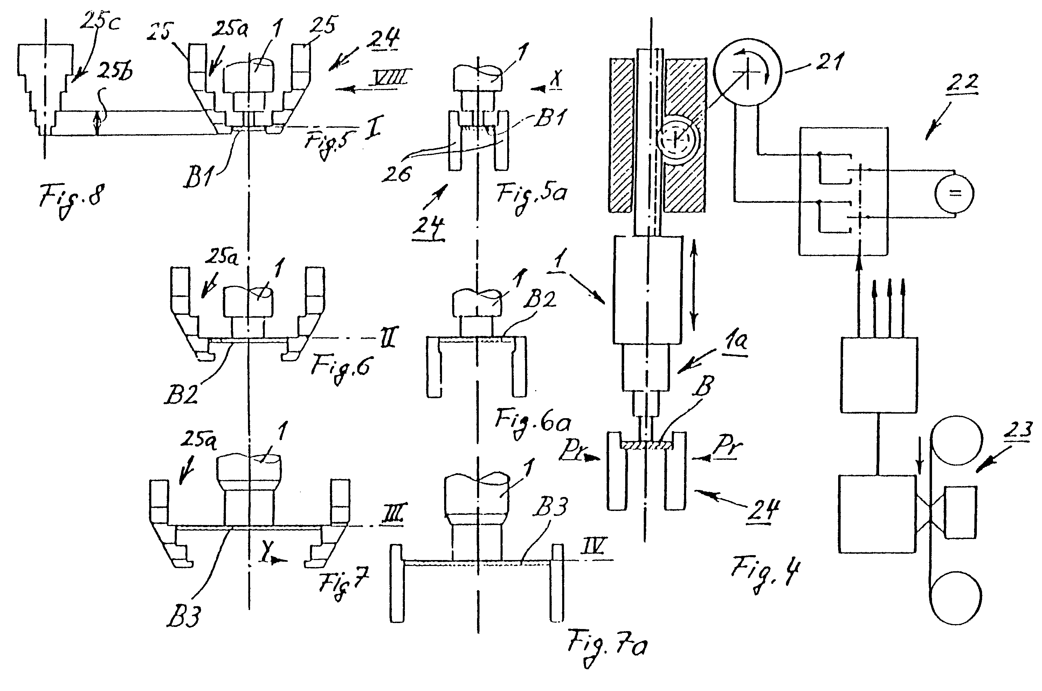

Bei der in Fig. 4 dargestellten Gesamtvorrichtung ist der Greifkörper 1 einschliesslich der Greifelement-Teleskopanordnung 1a mittels einer Führungs- und Antriebszahnstange 1b in einem schematisch blockartig angedeuteten Vorrichtungsgestell 1c vertikal verschiebbar gelagert. Die Zahnstange 1b steht mit einem Ausgangszahnrad 1d eines nicht näher dargestellten Getriebes in Wirkverbindung, das seinerseits mit einem richtungsumsteuerbaren Stellmotor 21 gekuppelt ist. Eine zugehörige Vertikalsteuervorrichtung 22 umfasst einen elektrisch ansteuerbaren Umschalter 22a, mittels dessen der Stellmotor 21 umpolbar an eine Gleichstromquelle 22b angeschlossen ist. Der Umschalter 22a weist neben seinen beiden gegensinnig gepolten Schaltstellungen eine stabile Abschalt-Mittelstellung auf, in welcher der Stellmotor 21 im Stillstand gehalten wird. Die jeweils vorgegebene der drei genannten Schaltstellungen wird über einen Ausgang 22d einer Steuerschaltung 22c auf den Umschalter 22a gegeben.

Weitere Ausgänge 22e sind für die Ansteuerung einer nicht dargestellten, zweiachsigen Horizontalsteuerung und einer Drehsteuerung für den um seine vertikale Längsachse drehbar gelagerten und mit einer entsprechenden Antriebsvorrichtung versehenen Greifkörper 1 vorgesehen. Die letztgenannten Vorrichtungsteile können von an sich bekanntem Aufbau sein und sind daher nicht näher dargestellt.

Wesentlich für den vorliegenden Erfindungsgegenstand ist jedoch ein programmierbarer Befehlsspeicher, der insgesamt mit 23 bezeichnet ist und ein beispielsweise als Magnetbandvorrichtung angedeutetes Speichermedium 23a mit Schreib-Lesestation 23b umfasst. Letztere ist in an sich üblicher Weise als Eingabestation für die Befehlsfolge der Prozessprogrammierung ausgebildet, insbesondere auch für die Aufnahme einer Mehrzahl von je einer vorgegebenen Vertikalstellung bzw. Einfahrstellung der Greifelement-Teleskopanordnung 1a zugeordneten Steuerbefehlen. Diese Steuerbefehle erlauben auch eine Zuordnung zu nach Grösse und/oder Form unterschiedlichen Bauteiloberflächen und damit die Ansteuerung entsprechender Einfahrstellungen der Greifelement-Teleskopanordnung mit Aktivierung der passenden Ansaugöffnungen, wie dies an Hand der Figuren 1 bis 3 erläutert worden ist.

Der Greifkörper 1 ist im Beispiel gemäss Fig. 4 in Verbindung mit einer Zentriervorrichtung 24 dargestellt, die entsprechend den Pfeilen Pr konzentrisch zur Greifkörperachse an einem vom Greifkörper in geeigneter Vertikalstellung gehaltenen Bauteil B angreift un dieses unter radialer Verschiebung bezüglich der Greifkörperache genau ausrichtet.

In den Figuren 5 bis 7 ist ein erstes Paar von zur Greifkörperachse konzentrischen Zentrierbacken 25 mit in Vertikalrichtung gestuftem, hinsichtlich seiner lichten Innenweite nach oben zunehmendem Innenprofil 25a dargestellt, und zwar in drei unterschiedlichen Radialstellungen entsprechend drei erfassten Bauteilen B1 bzw. B2 bzw. B3 unterschiedlicher Oberflächenabmessungen. Gemäss diesen unterschiedlichen Bauteilen nimmt der relativ zur Zentriervorrichtung 24 vertikal verfahrbare Greifkörper 1 unterschiedliche Vertikalstellungen in Bezug auf die Bauteiloberfläche ein, und zwar in der Weise, dass die Greifelement- Teleskopanordnung 1a eine der Aktivierung der passenden Saugöffnungen zugeordnete Einfahrstellung einnimmt. Diese Einfahrstellung kann z. B. bereits beim Aufnehmen des betreffenden Bauteils aus einer festen Ausgangslage oder auch bei in bestimmter Vertikallage durch die Zentrierbacken festgehaltenem Bauteil durch entsprechend programmierten Vertikalhub des Greifkörpers eingestellt werden.

Anschliessend wir das Bauteil mittels der beschriebenen Vertikalsteuerung in eine Höhenlage bezüglich der Zentriervorrichtung gebracht, die einer der Bauteilgrösse zugeordneten Stufe der Innenprofile 25a der Zentrierbacken 25 entspricht. Für das Bauteil B1 ist dies die unterste Stufe gemäss Höhenstellung I in Fig. 5, für das Bauteil B2 die zweitunterste Stufe gemäss Höhenstellung II in Fig. 6.

Wie aus Fig. 8 ersichtlich, sind die Zentrierbacken 25 auch in ihrer tangential zur Greifkörperachse gemessenen Breite mit einer nach oben zunehmenden Stufung 25c versehen, deren Hö- henstufen annähernd denjenigen der Innenprofi- lierung 25a entsprechen. Die Stufen sind so bemessen, dass der untere Endabschnitt 25b der Zentrierbacken 25 auch bei der Zentrierung von sehr kleinen Bauteilen zwischen ebenfalls ent- sprechend eng zusammengefahrene Zentrier- backen 26 eines zweiten, bezüglich der Greifkörperachse um 90° verdreht angeordneten Backenpaares eingreifen kann. Letztere sind in den zugehörigen Figuren 5a und 6a dargestellt. Beide Backenpaare können daher unter radialer Zustellung ihre Zentrierfunktion in den beiden horizontalen Koordinatenrichtungen gemäss Pfeil x bzw. y gleichzeitig ausführen, während das Bauteil B1 bzw. B2 seine Höhenlage I bzw. II einnimmt.

Bei der Zentrierung grösserer Bauteile, wie z. B. für das Bauteil B3 in den Figuren 7 und 7a dargestellt, kann dagegen unter Berücksichtigung eines begrenzten Horizontalhubes der Zentrierbacken 25 die Zentrierung in y-Richtung in der Höhenstellung III mit entsprechend grösserer lichter Innenbreite der Profilierung 25a vorgenommen werden und danach unabhängig von den Backen 25 in einer tieferen Höhenlage IV die Zentrierung in x-Richtung mittels der Backen 26. Hierzu sind die Backen 25 in nicht näher dargestellter Weise so zu verfahren, dass sie die Absenkung in die letztgenannte Höhenlage nicht behin- dern.

## Patentansprüche

1. Vorrichtung zur Aufnahme und zum Transport von Bauteilen mit einem gegen das Bauteil hin und zurück bewegbaren Greifkörper, der langgestreckt sowie hohl und endseitig offen ausgebildet und mit einem Unterdruckanschluss versehen ist, dadurch gekennzeichnet, dass der Greifkörper (1) eine Teleskopanordnung mit einem Greifkörper-Grundelement (2) und minde- stens zwei konzentrisch zueinander angeordne- ten, gegeneinander verschiebbaren Greifelemen- ten (4, 8, 11) aufweist, dass das Greifkörper- Grundelement ein erstes (4) der Greifelemente axial verschiebbar aufnimmt, welches seinerseits ein zweites (8) der Greifelemente axial verschiebbar aufnimmt, dass die Greifelemente je mit in ihren bauteilseitigen Stirnflächen angeordneten Saugöffnungen (17, 18, 20) versehen sind, dass die Greifelemente (4, 8) eine erste Arbeitsstellung einnehmen können, in der die Stirnfläche des ersten Greifelements von dem Bauteil weiter entfernt ist als die Stirnfläche des zweiten Greifelements, dass die Greifelemente eine zweite Arbeitsstellung einnehmen können, in der ihre Stirnflächen in einer gemeinsamen Ebene liegen, dass der Unterdruckanschluss (3) an dem Greifkörper-Grundelement angeordnet ist, dass der Greifkörper mit Steuermitteln versehen ist, die in Abhängigkeit von der gegenseitigen Lage der Greifelemente Verbindungen zwischen den Saugöffnungen eines oder mehrerer Greifelemente und dem Unterdruckanschluss öffnen oder schliessen und zwar derart, dass in der ersten Arbeitsstellung die Verbindung zwischen der Saugöffnung in der Stirnseite des ersten Greifelements und dem Sauganschluss unterbrochen ist, wohingegen in der zweiten Arbeitsstellung die Verbindung der Saugöffnungen sowohl des ersten als auch des zweiten Greifelements mit dem Unterdruckanschluss offen ist und dass die Steuermittel Radialbohrungen (7, 15, 16) der Greifelemente sowie Durchlässe zur Verbindung der Saugöffnungen mit dem Unterdruckanschluss und an den Greifelementen gebildete Steuerkanten für das von der Relativstellung der Greifkörperteile abhängige Öffnen bzw. Schliessen der Durchlässe aufweisen.

2. Vorrichtung nach Anspruch 1, dadurch gekennzeichnet, dass das zweite Greifelement (8) ein drittes Greifelement (11) axial verschiebbar aufnimmt.

3. Vorrichtung nach einem der Ansprüche 1 oder 2, dadurch gekennzeichnet, dass der Greifkörper (1) vertikal bewegbar gelagert sowie mit einem Vertikal-Stellantrieb (21) und einer programmierbaren Vertikalsteuerung (22) versehen ist und dass die Vertikalsteuerung (22) einen programmierbaren Befehlsspeicher (23) zur Aufnahme einer Mehrzahl von je einer vorgegebenen Vertikalstellung bzw. Einfahrstellung (I, II, III) der Greifelement-Teleskopanordnung (1a) zugeordneten Steuerbefehlen aufweist.

4. Vorrichtung nach Anspruch 3, dadurch gekennzeichnet, dass der Befehlsspeicher (23) zur Aufnahme von Steuerbefehlen für verschiedenen Bauteiloberflächen zugeordneten Einfahrstellungen (I, II, III) der Greifelement-Teleskopanordnung (1a) vorgesehen ist.

5. Vorrichtung nach einem der vorhergehenden Ansprüche, dadurch gekennzeichnet, dass der Greifkörper (1) mit einer Bauteil-Zentriervorrichtung (24) verbunden ist, die mindestens ein Paar von konzentrisch zu dem Greifkörper angeordnete Zentrierbacken (25) mit in Vertikalrichtung gestuftem Innenprofil (25a) aufweist, und dass der Greifkörper (1) relativ zu den Zentrierbacken vertikal verfahrbar ausgebildet ist.

6. Vorrichtung nach Anspruch 5, dadurch gekennzeichnet, dass die lichte Weite der Zentrierbackenstufen von Sufe zu Stufe in Vertikalrichtung nach oben zunimmt.

7. Vorrichtung nach Anspruch 5 oder 6, dadurch gekennzeichnet, dass die Zentrierbacken (25) eine quer zur Ebene des Backenpaares gemessene Breite aufweisen, die vom unteren Ende der Backen nach oben zunimmt.

8. Vorrichtung nach Anspruch 7, dadurch gekennzeichnet, dass die Breite der Zentrierbacken (25) nach oben stufenförmig zunimmt.

9. Vorrichtung nach Anspruch 8, dadurch gekennzeichnet, dass die in Vertikalrichtung gemessenen Höhen der Sufen der Backenbreite im wesentlichen entsprechend den in gleicher Höhe angeordneten Stufen des Backeninnenprofils bemessen sind.

10. Vorrichtung nach einem der Ansprüche 7 bis 9 dadurch gekennzeichnet, dass in an sich bekannter Weise zwei über Kreuz und konzentrisch zu dem Greifkörper (1) angeordnete Paare von Zentrierbacken (25, 26) vorgesehen sind, wobei die Zentrierbacken (25) des ersten Paares gestufte Backeninnenprofile und von unten nach oben zunehmende Backenbreiten aufweisen und mit einem unteren Endabschnitt (25b) zwischen die Zentrierbacken (26) des zweiten Paares eingreifen.

**Claims**

1. Device for picking up and conveying components with a gripper body movable backwards and forwards against the component, which is elongated, hollow and terminally open and provided with a vacuum connection, characterized in that the gripper body (1) has a telescopic arrangement with a gripper body basic element (2) and at least two concentrically reciprocally arranged and oppositely displaceable gripping elements (4, 8, 11), that the gripper body basic element receives a first (4) of the gripping elements in axially displaceable manner and which in turn receives in axially displaceable manner a second (8) of the gripping elements, that each of the gripping elements is provided with suction openings (17, 18, 20) arranged in the component-side end faces thereof, that the gripping elements (4, 8) can assume a first working position, in which the end face of the first gripping element is further removed from the component than the end face of the second gripping element, that the gripping elements can assume a second working position, in which their end faces are located in a common plane, that the vacuum connection (3) is located on the gripper body basic element, that the gripper body is provided with control means which, as a function of the reciprocal position of the gripping elements, open or close connections between the suction openings of one or more gripping elements and the vacuum connection in such a way that in the first working position the connection between the suction opening in the end face of the first gripping element and the suction connection is broken, whereas in the second working position the connection of the suction openings both of the first and the second gripping element with the vacuum connection is open and that the control means have radial bores (7, 15, 16) of the gripping element and passages for the connection of the suction openings to the vacuum connection and on the control edges formed on the gripping elements for the opening or closing of the passages as a function of the relative position of the gripper body parts.

2. Device according to claim 1, characterized in that the second gripping element (8) receives a third gripping element (11) in axially displaceable manner.

3. Device according to one of the claims 1 or 2, characterized in that the gripper body (1) is vertically movably mounted and provided with a vertical servodrive (21) and a programmable vertical control (22) and that the latter has a programmable instruction memory (23) for receiving a plurality of control instructions associated in each case with a given vertical or insertion position (I, II, III) of the gripping element telescopic arrangement (1a).

4. Device according to claim 3, characterized in that the instruction memory (23) is provided for receiving control instructions for insertion positions (I, II, III) of the gripping element telescopic arrangement (1a) associated with the different component surfaces.

5. Device according to one of the preceding claims, characterized in that the gripper body (1) is connected to a component centring device (24), which has at least one pair of centring jaws (25) arranged concentrically to the gripper body with an inner profile (25a) stepped in the vertical direction and that the gripper body (1) is constructed so as to be vertically movable relative to the centring jaws.

6. Device according to claim 5, characterized in that the inside width of the centring jaw steps increases upwards in the vertical direction between the individual steps.

7. Device according to claims 5 or 6, characterized in that the centring jaws (25) have a width measured at right angles to the plane of the jaw pair and which increases upwards from the lower end of the jaws.

8. Device according to claim 7, characterized in that the width of the centring jaws (25) increases upwards in steplike manner.

9. Device according to claim 8, characterized in that the heights of the steps of the jaw width measured in the vertical direction are substantially dimensioned so as to correspond to the steps of the jaw inner profile arranged at the same height.

10. Device according to one of the claims 7 to 9, characterized in that in per se known manner two pairs of centring jaws (25, 26) arranged in crossed manner and concentrically to the gripper body (1) are provided, the centring jaws (25) of the first pair have stepped jaw inner profiles and jaw widths increasing from the bottom to the top and with a lower end portion (25b) engaged between the centring jaws (26) of the second pair.

**Revendications**

1. Dispositif de prélèvement et de transport de composants, comportant un corps de préhension se déplaçant dans un mouvement de va-et-vient par rapport au composant, qui est allongé, creux, et ouvert d'un côté, et est pourvu d'un branchement de dépression, caractérisé en ce que le corps de préhension (1) comporte un dispositif télescopique avec un élément de base (2) du corps de préhension et au moins deux éléments de préhension (4, 8, 11) concentriques, coulissant les uns par rapport aux autres, en ce que l'élément de base du corps de préhension loge un premier (4) élément de préhension coulissant axialement, lequel loge de son côté un deuxième (8) élément de préhension coulissant axialement, en ce que les éléments de préhension sont pourvus chacun d'ouvertures d'aspiration (17, 18, 20) pratiquées dans les faces frontales, du côté du composant, en ce que les éléments de préhension (4, 8) peuvent prendre une première position de travail dans laquelle la face frontale du premier élément de préhension est plus éloignée du composant que la face frontale du deuxième élément de préhension, en ce que les éléments de préhension peuvent prendre une deuxième position de travail dans laquelle leurs faces frontales se situent dans un plan commun, en ce que le branchement de dépression (3) est placé sur l'élément de base du corps de préhension, en ce que le corps de préhension est pourvu de moyens de commande qui ouvrent ou ferment des liaisons entre les ouvertures d'aspiration d'un ou de plusieurs éléments de préhension et le branchement de dépression, en fonction de la position relative des éléments de préhension, et ce de manière que dans la première position de travail la communication entre l'ouverture d'aspiration pratiquée dans la face frontale du premier élément de préhension et le branchement d'aspiration, soit interrompue, tandis que dans la deuxième position de travail, la communication entre les ouvertures d'aspiration du premier et du deuxième éléments de préhension, et le branchement de dépression est ouverte, et en ce que les moyens de commande présentent des perçages radiaux (7, 15, 16) des éléments de préhension, ainsi que des passages pour la liaison entre les ouvertures d'aspiration et le branchement de dépression, et des arêtes de commande formées sur les éléments de préhension, pour l'ouverture ou la fermeture des passages, en fonction de la position relative des éléments du corps de préhension.

2. Dispositif selon la revendication 1, caractérisé en ce que le deuxième élément de préhension (8) loge un troisième élément de préhension (11) coulissant axialement.

3. Dispositif selon l'une des revendications 1 ou 2, caractérisé en ce que le corps de préhension (1) est monté de manière à pouvoir se déplacer verticalement, et est pourvu d'un servomécanisme de position verticale (21), et d'une commande verticale (22) programmable, et en ce que la commande verticale (22) comporte une mémoire d'instructions (23) programmable pour l'enregistrement d'une série d'instructions de commande associées chacune à une position verticale ou position rentrée donnée (I, II, III) du dispositif télescopique à éléments de préhension (1a).

4. Dispositif selon la revendication 3, caractérisé en ce que la mémoire d'instructions (23) est prévue pour l'enregistrement d'instructions de commande pour différentes positions rentrées (I, II, III) associées à différentes surfaces de composants, du dispositif télescopique à éléments de préhension (1a).

5. Dispositif selon l'une des revendications précédentes, caractérisé en ce que le corps de préhension (1) est relié à un centreur de composants (24) qui comporte au moins une paire de mâchoires de centrage (25) concentriques au corps de préhension, présentant un profil intérieur (25a) étagé verticalement, et en ce que le corps de préhension (1) est conçu de manière à se déplacer verticalement par rapport aux mâchoires de centrage.

6. Dispositif selon la revendication 5, caractérisé en ce l'ouverture intérieure des gradins des mâchoires de centrage augmente verticalement vers le haut, d'un gradin à l'autre.

7. Dispositif selon la revendication 5 ou 6, caractérisé en ce que les mâchoires de centrage (25) ont une largeur mesurée perpendiculairement au plan de la paire de mâchoires, qui augmente de l'extrémité inférieure des mâchoires vers le haut.

8. Dispositif selon la revendication 7, caractérisé en ce que la largeur des mâchoires de centrage (25) augmente vers le haut par gradins.

9. Dispositif selon la revendication 8, caractérisé en ce que les hauteurs des gradins de la largeur des mâchoires, mesurées verticalement, ont à peu près les mêmes dimensions que les gradins du profil intérieur des mâchoires, disposés à même hauteur.

10. Dispositif selon l'une des revendications 7 à 9, caractérisé en ce qu'il est prévu deux paires de mâchoires de centrage (25, 26), disposées de manière connue en soi, en croix et concentriquement au corps de préhension (1), les mâchoires de centrage (25) de la première paire présentant des profils intérieurs étagés, et des largeurs de mâchoires augmentant de bas en haut, et s'engageant par une section terminale (25b) inférieure entre les mâchoires de centrage (26) de la deuxième paire.

EP 0 226 033 B1

FIG. 1

FIG. 2

1

1

2

9

10

8

3

12

7

11

14

5

15

16

6

13

11a

4

8b

4a

X

X

8a

18

17

FIG. 3

Fig.8

Fig.5   I

B1

Fig.5a

24

Fig.6

B2

Fig.6a

Fig.7

B3

Fig.7a

Fig.4

21

22

23

24

EP 0 226 033 B1